# EUROPEAN PATENT SPECIFICATION

(11) **EP 3 295 490 B1**
(45) Date of publication and mention of the grant of the patent: **18.03.2020**
(21) Application number: 16730517.6
(22) Date of filing: 06.05.2016
(51) Int. Cl.: H01L 31/0224, H01L 31/0236, H01L 31/074, H01L 31/18

(54) **PHOTOVOLTAIC CELL STRUCTURE AND METHOD TO PRODUCE THE SAME**
PHOTOVOLTAISCHE ZELLSTRUKTUR UND VERFAHREN ZUR HERSTELLUNG DAVON
STRUCTURE DE CELLULE PHOTOVOLTAÏQUE ET SON PROCÉDÉ DE PRODUCTION

(30) Priority: 08.05.2015 PL 41225015
(43) Date of publication of application: 21.03.2018
(73) Proprietor: Instytut Fizyki Pan, 02-668 Warszawa (PL)
(72) Inventor: GIERALTOWSKA, Sylwia, 03-984 Warszawa (PL); GODLEWSKI, Marek, 03-543 Warszawa (PL); PIETRUSZKA, Rafal, 27-612 Wilczyce (PL); WACHNICKI, Lukasz, 01-947 Warszawa (PL); WITKOWSKI, Bartlomiej, 03-138 Warszawa (PL)
(74) Representative: Witek, Rafal
(86) International application number: PCT/PL2016/050016
(87) International publication number: WO 2016/182465

(56) References cited:
- WO-A1-2015/128825
- US-A1- 2010 180 950
- RAFAL PIETRUSZKA ET AL: "Photovoltaic properties of ZnO nanorods/p-type Si heterojunction structures", BEILSTEIN JOURNAL OF NANOTECHNOLOGY, vol. 5, 14 February 2014 (2014-02-14), pages 173-179, XP055198989, DOI: 10.3762/bjnano.5.17
- R. PIETRUSZKA ET AL: "Electrical and photovoltaic properties of ZnO/Si heterostructures with ZnO films grown by atomic layer deposition", THIN SOLID FILMS, vol. 563, 1 July 2014 (2014-07-01), pages 28-31, XP055199002, ISSN: 0040-6090, DOI: 10.1016/j.tsf.2013.10.110 cited in the application
- K. E. KNUTSEN ET AL: "Prediction of high efficiency ZnMgO/Si solar cells suppressing carrier recombination by conduction band engineering", PHYSICA STATUS SOLIDI. A: APPLICATIONS AND MATERIALS SCIENCE, vol. 210, no. 3, 27 March 2013 (2013-03-27), pages 585-588, XP055300497, DE ISSN: 1862-6300, DOI: 10.1002/pssa.201228527 cited in the application

## Description

This invention relates to a photovoltaic cell structure and method to produce the same. Such structures can be used as an electric energy source since they generate voltage on illumination.

There are descriptions of various kinds of photovoltaic structures in scientific and patent literature. The most popular ones comprise silicon photovoltaic cells PV that constitute almost 90% of the photovoltaic market. Currently, there are commercially available PV panels comprising monocrystalline, polycrystalline, and amorphous thin layer silicon cells. Although significant progress in PV cells/structures based both on monocrystalline and polycrystalline silicon has been observed, the manufacturing technology is still too expensive and in the majority of cases it is simply uneconomical. The remaining 10% of the photovoltaic market consists of photovoltaic cells based on thin-layer materials such as cadmium telluride (CdTe), cadmium sulphide (CdS), copper-indium-gallium-selenide alloys (CIGS), and multi-junction cells using A^{III}B^{V} materials. The drawback of thin-layer CdTe-CdS cells is their high price (especially the costs of Tellurium that is also to scarce to meet the photovoltaics market demand) as well as their negative environmental impact due to the application of cadmium. Another aspect limiting the applicability of CdTe based technology are the problems connected with the performance of ohmic contacts both for p-type CdTe and n-type CdS. These impediments make CdTe and CdS difficult materials for photovoltaics. In case of cells based on copper-indium-gallium-selenide alloy (CIGS), the problem is similar since the most commonly used partner for p-type conductivity of CIGS is CdS. Cells containing multiple layers of various materials, so called multi-junction cells made by Molecular Beam Epitaxy (MBE) and by Chemical Vapor Deposition (CVD) are also known. Structures of such cells are generally built of three layers. The lower layer is a base layer of germanium (Ge), the middle layer is a InGaAs multilayer, and the upper layer is also multilayer of InGaP. The efficiency of the triple-junction cells is in fact the highest (of the magnitude of 40% in laboratory conditions), but their manufacturing cost is very high which makes their mass production impossible. Besides, the method of obtaining time stable tunnel layers is very complex, and those high efficiencies are used only under concentrated lightning, but then the problem of such cells getting hot appears. From a publication by R. Pietruszka, G. Luka, B.S. Witkowski, K. Kopalko, E. Zielony, P. Bieganski, E. Placzek-Popko, M. Godlewski, "Electrical and photovoltaic properties of ZnO/Si heterostructures with ZnO films grown by atomic layer deposition", Thin Solid Films, doi: 10.1016/j.tsf.2013.10.110, a photovoltaic cell structure is knows, being created by means of the Atomic Layer Deposition (ALD) technology. The structure is a triple-layer structure in the arrangement of: p-type semiconductor / n-type semiconductor / transparent electrode. The substrate in this structure is a p-type semiconductor that is the first layer, the second layer is a (n-type) layer of zinc oxide, and the third layer is a layer of zinc oxide doped with aluminum. The cost to produce such structure is relatively low as compared to that of commercially produced structures, and the efficiency of the cell made of such structures reaches 6%. Polish Patent Application PL407336, also published as WO 2015/128825A, discloses a cell consisting of a substrate in the form of p-type silicon, covered with a layer of ZnO nanorods that are in turn covered with a layer ZnO. The function of the upper layer covering the nanorods is the extend the Si/ZnO junction that constitutes the active element of the cell. In the method according to the present invention, ZnO nanostructures on the silicon substrate are covered with a ZnMgO layer that, unlike the one according to the application referred to above, is not designed to extend the junction area, but to improve the transparency of the upper cell layers that do not actively participate in light absorption. The above solution resulted in that the achieved efficiency is 1,5% higher and is 14%. In the theoretical work by K. E. Knutsen, R. Schifano, E. S. Marstein, B. G. Svensson, A. Yu. Kuznetov, "Prediction of high Efficiency ZnMgO/Si solar cells suppressing carrier recombination by conduction band engineering", Physica Status Solodi A, doi: 10.1002/pssa.201228527, a photovoltaic ZnMgO/Si structure is contemplated. A detailed analysis of the influence of the magnesium doping to the photovoltaic response of a ZnMgO/Si cell has been carried out in that work. Theoretical computations indicate the possibility to move the conductivity level of ZnMgO away from the silicon valence level. Therefore, the influence of recombination centers is strongly reduced. This effect leads to the increase of obtained efficiencies in such photovoltaic structures. A photovoltaic cell with extended working spectral range enabling absorbing near-UV range with relatively cheap production technology and high efficiency is still being sought. The object of the invention is to develop a photovoltaic structure of increased efficiency and relatively cheap production method of such structure. RAFAL PIETRUSZKA ET AL: "Photovoltaic properties of ZnO nanorods/p-type Si heterojunction structures",BEILSTEIN JOURNAL OF NANOTECHNOLOGY, vol. 5, 14 February 2014 (2014-02-14), pages 173-179 relates to photovoltaic structures based on n-ZnO nanorods grown on p-Si substrates.

The first object of the present invention is a photovoltaic cell structure according to claim 1.

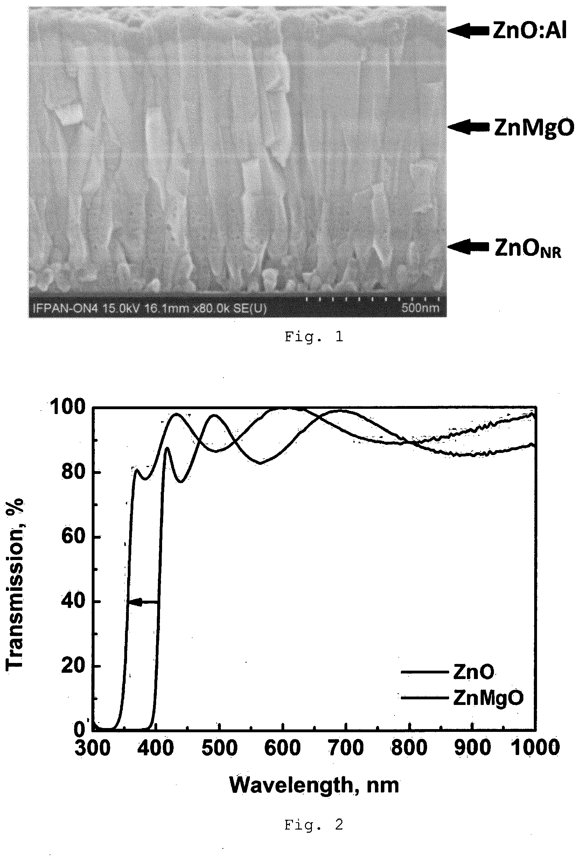

The second object of the present invention is the method to produce photovoltaic cell, wherein layer containing ZnO and ZnMgO covered with a deposited transparent ZnO:Al layer with an electric contact is deposited on a p-type substrate with a bottom electric contact, wherein a layer of ZnO nanostructures in the form on nanorods covered with a ZnMgO is created upon a silicon substrate, and the ZnMgO layer has a column growth mode upon the ZnO nanostructures, wherein in order to create the said layer, the substrate is first covered with a nucleating layer and then the substrate with the nucleating layer is placed in a reacting mixture with pH of 6.5-12, containing a solvent, at least one oxygen precursor and at least one zinc precursor, zinc concentration being from 0.001 M/dm3 to 1 M/dm3, heated up to the temperature of 30-95°C and maintained at that temperature for at least 1 second, and upon completion of the process, impurities are removed from the crystallized nanostructures, preferably by annealing for at least 1 second in the temperature of ≥ 100°C, after which the ZnO nanostructures are covered with a ZnMgO layer at least 1 nm thick in an ALD process, and so created active layer is covered with a transparent ZnO:Al electrode upon which the upper electric contact is made. In order to produce the ZnO nanostructures layer, the substrate is first covered with the nucleating layer. The nucleating layer can be a layer of gold, silver or nanoparticles thereof deposited by means of sputtering process or the ZnO layer, or ZnO nanoparticles deposited from a solution or obtained by annealing zinc salt (e.g. zinc acetate) deposited from solution or deposited in at least 1 ALD cycle, using diethylzinc, dimethylzinc or zinc chloride as zinc precursor, and water, ozone or oxygen plasma as oxygene precursor. Having deposited the nucleating layer, the substrate is placed in a solution with pH of 6.5 to 12, containing a solvent, at least one oxygen precursor and at least one zinc precursor, heated to the temperature of 30-95°C and kept at this temperature for at least 1 second. Zinc concentration in the solution should be higher than 0.001 M/dm³, and lower than 1 M/dm³. It is preferred when the oxygen precursor in the reaction mixture is water, and the zinc precursor is zinc acetate. The pH of the solution is adjusted by precipitation with a metal hydroxide solution (e.g. NaOH, KOH). After the process is completed, contamination is removed from crystalline ZnO nanorods, preferably by annealing for at least 1 second in the temperature of ≥100°, after which the ZnO nanorodes are covered with a ZnMgO layer in an ALD process. It is preferred that the ZnMgO layer be deposited in at least 10 ALD cycles, using diethylzinc, dimethylzinc or zinc chloride as zinc precursor, bis(cyclopentadienyl)magnesium or bis(methylcyclopentadienyl)magnesium as magnesium precursor, and water, ozone or oxygen plasma as oxygen precursor. Next, the layer of ZnO nanostructures covered with the ZnMgO layer is covered with the transparent ZnO:Al electrode layer, and top electric contact is made. It is preferred that the transparent ZnO layer doped with aluminum be deposited in at least 100 ALD cycles, using diethylzinc, dimethylzinc or zinc chloride as zinc precursor, water, ozone or oxygen plasma as oxygen precursor, and trimethylaluminum as aluminum precursor. The solution according to the present invention uses the ZnMgO layer that is deposited on ZnO nanorods. According to the invention, the junction is created by joining n-ZnO and p-Si semiconductor nanostructures together. The present invention utilizes the new effects of magnesium doping influence upon the ZnO layer. First of all, the influence of magnesium doping upon the resistivity and growth mode of the layer is used. By selecting appropriate conditions between Zn, O, and Mg atoms concentration, the resistivity or the ZnO layer changes within the 10⁻² to 10² Ωcm range. Also, column growth mode of ZnMgO layer is observed on nanorods (fig. 1). Columns of ZnMgO grow epitaxially on ZnO nanorods replicating their high crystallographic quality. Due to that phenomenon, monocrystalline ZnMgO columns are grown on ZnO_{NR}, effectively separating the carriers and providing them to the upper electrode. Another effect of magnesium doping influence upon ZnO layer taken advantage of is the extension of the spectral range of the ZnMgO/ZnO_{NR}/Si photovoltaic cell operation. This effect enables the structure absorbing near UV area that translates into the increased number of photo-generated electric current carriers. Figure 2 illustrates the influence of magnesium doping upon increasing ZnO layer transparency. The effect allows photons from near UV area reach the junction area and actively participate in creation of electron-hole pairs. The obtained structure generates electrical voltage when subjected to visible, infrared, and near-UV light spectrum. The technology to produce the photovoltaic structure according to the present invention is cheap and simple, and the structure is a reusable one.

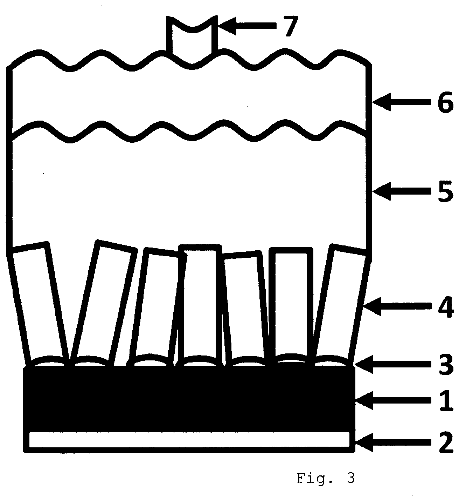

The invention will be now explained in a more detailed way by means of the Al/ZnO:Al/ZnMgO/ZnO_{NR}/Si/Al photovoltaic structure embodiment and the drawings, where Fig. 1 illustrates the column growth mode of ZnMgO layer upon ZnO nanorods, fig. 2 illustrates the extension of spectral transparency of the ZnO layer doped with magnesium, and fig. 3 illustrate the structure according to the invention. Example 1

To carry out the example structure, commercially available p-type silicon substrate with electrical resistivity of 2.3 Ωcm and dimensions of 1.5 x 1.5 cm was used. First, the substrate was subjected to cleaning that was carried out in a ultrasonic washer. The substrate was rinsed in 3 steps of 30 seconds each, in isopropanol, acetone, and deionized water, respectively. Aluminum film 2, constituting the bottom electric contact, was deposited with cathode sputtering upon the cleaned substrate 1. In the second step, the creation of the active ZnO layer in the form of ZnO nanorods 4 covered with thin film of ZnO 5 upon the cleaned substrate was commenced. For that purpose, first, silver nanoparticles constituting the nucleation layer 3 for hydrothermal growth of nanorods were deposited upon the upper surface of the substrate 1 also by cathode sputtering. Next, the substrate with the nuclei was placed in 100 ml of a reaction mixture containing 1g dissolved zinc acetate and brought to the pH equal 8 by precipitation by 1-mol sodium hydroxide solution. The mixture with the substrate was heated to the temperature of 50°C and the growth of nanorods to the height of 650 nm was continued in that temperature for 2 minutes. After the growth completed, the substrate 1 with the crystallized nanorods 4 was rinsed in isopropanol to remove possible impurities, and deposition of ZnO layer 5 upon them started. For that purpose, the substrate was placed in an ALD reactor where it was annealed for 2 minutes in 200°C. After annealing, the reactor chamber was cooled down to 160°C, and the ZnO nanorods were thoroughly covered with a ZnMgO layer ca. 200 nm thick in 1000 ALD cycles at that temperature. The ZnMgO layer 5 was deposited with diethylzinc as zinc precursor, water as oxygen precursor, and bis(methylcyclopentadienyl)magnesium as magnesium precursor. Further on, at the same temperature and without removing the substrate with the deposited ZnO nanostructures covered with ZnMgO layer from the ALD reactor, the transparent electrode layer 6 in the form of ZnO:Al and thickness of 300 nm being the upper transparent electrode 6 was deposited. The electrode layer 6 was deposited with dietylzinc as zinc precursor, water as oxygen precursor, and trimethylaluminum as aluminum precursor. Having deposited electrode layer 6, the point ohmic contact with the ZnO:Al layer 7, made of aluminum, was deposited by cathode sputtering process. Coating the ZnO nanorods with the ZnMgO layer increased the transparency of the upper part of the cell that does not participate in absorption, which significantly influenced the efficiency of the structure according to the present invention. The obtained structure demonstrated the efficiency of 14% (laboratory measurements made with sunlight simulator).

### Example 2

To carry out the second example structure, commercially available p-type silicon substrate with electrical resistivity of 2.3 Ωcm and dimensions of 1.5 x 1.5 cm was also used. First, the substrate was subjected to cleaning that was carried out in a ultrasonic washer. The substrate was washed for 30 seconds, consecutively in deionized water. Aluminum film 2, constituting the bottom electric contact, was deposited with cathode sputtering upon the cleaned substrate 1. In the second step, the creation of the active ZnO layer in the form of ZnO nanorods 4 covered with thin film of ZnO 5 upon the cleaned substrate was commenced. For that purpose, nanoparticles ZnO being the nucleation layer 3 for hydrothermal growth of nanorods were deposited upon the upper surface of the substrate 1 in 10 ALD cycles and temperature of 100°C, using water as oxygen precursor and diethylzinc as zinc precursor. Next, the substrate with the nuclei was placed in 110 ml of a reaction mixture containing 2g dissolved zinc acetate and brought to the pH equal 7.7 by precipitation with 1-mol potassium hydroxide solution. The mixture with the substrate was heated to the temperature of 70°C and the growth of nanorods to the height of 1200 nm was continued in that temperature for 2 minutes. After the growth completed, the substrate 1 with the crystallized nanorods 4 was rinsed in isopropanol to remove possible impurities, and deposition of ZnO layer 5 upon them started. For that purpose, the substrate was placed in an ALD reactor where it was annealed for 2 minutes in 200°C. After annealing, the reactor chamber was cooled down to 160°C, and the ZnO nanorods were thoroughly covered with a ZnMgO layer ca. 1000 nm thick in 4000 ALD cycles at that temperature. The ZnMgO layer 5 was deposited with diethylzinc as zinc precursor, water as oxygen precursor, and bis(methylcyclopentadienyl)magnesium as magnesium precursor. Further on, at the same temperature and without removing the substrate with the deposited ZnO nanostructures covered with ZnMgO layer from the ALD reactor, the transparent electrode layer 6 in the form of ZnO:Al and thickness of 500 nm being the upper transparent electrode 6 was deposited. The electrode layer 6 was deposited with diethylzinc as zinc precursor, water as oxygen precursor, and trimethylaluminum as aluminum precursor. Having deposited electrode layer 6, the point ohmic contact with the ZnO:Al layer 7, made of aluminum, was deposited by cathode sputtering process. The obtained structure demonstrated the efficiency of 5% (laboratory measurements made with sunlight simulator). On application of higher ZnO nanorods or even thicker ZnMgO layer, the cell efficiency decreases dramatically. For nanorods higher than 2000 nm and ZnMgO layer thicker than 2000 nm, the cell efficiency is close to 0 - the cell stops working.

## Claims

1. A photovoltaic cell structure, containing a p-type silicon semiconductor substrate (1) with a bottom electric contact (2), with a layer comprising ZnO and ZnMgO covered with a transparent conductive layer (6), preferably a ZnO:Al layer, with an upper electric contact (7), wherein the active layer is a Si/ZnO/ZnMgO junction, wherein a layer of ZnO nanostructures (4) of the height of 100 nm up to 2000 nm is covered with a ZnMgO layer (5) from 1 nm to 2000 nm thick, the ZnMgO (5) layer having a column growth mode upon the ZnO nanostructures (4), wherein a nucleating layer (3) on the silicon substrate (1) for growing the ZnO nanostructures (4) is a layer of gold, silver or ZnO, or nanoparticles of these materials.

2. The method to produce a photovoltaic cell, wherein a layer containing ZnO and ZnMgO covered with a deposited transparent ZnO:Al layer with an upper electric contact is deposited on a p-type substrate with a bottom electric contact, wherein a layer of ZnO nanostructures in the form of nanorods covered with a ZnMgO layer (5) is created upon a silicon substrate (1), wherein in order to create the layer of ZnO nanostructures, the substrate (1) is first covered with a nucleating layer (3) and then the substrate (1) with the nucleating layer (3) is placed in a reacting mixture with pH of 6.5-12, containing a solvent, at least one oxygen precursor and at least one zinc precursor, zinc concentration being from 0.001 M/dm3 to 1 M/dm3, heated up to the temperature of 30-95°C and maintained at that temperature for at least 1 second, and upon completion of the process, impurities are removed from the crystallized nanostructures (4), preferably by annealing for at least 1 second in the temperature of ≥ 100°C, after which the ZnO nanostructures are covered with a ZnMgO layer (5) at least 1 nm thick in an ALD process, and the so created active layer is covered with a transparent ZnO:Al electrode (6) upon which the upper electric contact is made (7).

3. The method of claim 2, **characterized in that** the nucleating layer (3) is deposited on the substrate (1) by means of cathode sputtering of gold, silver, or nanoparticles of these metals.

4. The method of claim 2, **characterized in that** the nucleating layer (3) is a ZnO layer or ZnO nanoparticles deposited on the substrate (1) from a solution or obtained by annealing zinc salts deposited from a solution, or deposited in at least 1 ALD cycle, the precursor of zinc being diethylzinc, dimethylzinc or zinc chloride, and the precursor of oxygen being water, ozone, or oxygen plasma.

5. The method of claim 2, **characterized in that** the oxygen precursor in the reaction mixture is water, and the zinc precursor is zinc acetate.

6. The method of claim 2, **characterized in that** the ZnMgO layer (5) that the active layer nanorods (4) are covered with is deposited in at least 10 ALD cycles, using diethylzinc, dimethylzinc or zinc chloride as zinc precursor, bis(cyclopentadienyl)magnesium or bis(methylcyclopentadienyl)magnesium as Mg precursor, and water, ozone or oxygen plasma as oxygen precursor.

7. The method of claim 2, **characterized in that** the transparent ZnO:Al (6) layer is deposited in at least 100 ALD cycles, using diethylzinc, dimethylzinc or zinc chloride as zinc precursor, water, ozone or oxygen plasma as oxygen precursor, and trimethylaluminum as aluminum precursor.

## Patentansprüche

1. Eine photovoltaische Zellstruktur, beinhaltend ein Siliziumhalbleitersubstrat (1) vom P-Typ mit einem unteren elektrischen Kontakt (2), mit einer Schicht umfassend ZnO und ZnMgO, welche mit einer transparenten leitenden Schicht (6), vorzugsweise mit einer ZnO:Al-Schicht bedeckt ist, mit einem oberen elektrischen Kontakt (7), wobei die aktive Schicht eine Si/ZnO/ZnMgO-Junktion ist, wobei eine Schicht aus ZnO-Nanostrukturen (4) der Höhe von 100 nm bis zu 2000 nm mit einer von 1 nm bis 2000 nm dicken ZnMgO-Schicht (5) bedeckt ist, wobei die ZnMgO-Schicht (5) einen Säulenwachstumsmodus auf der ZnO-Nanostruktur (4) hat, wobei eine Nukleationsschicht (3) auf dem Siliziumsubstrat (1) zum Wachsen der ZnO-Nanostruktur (4) eine Schicht aus Gold, Silber oder ZnO, oder aus Nanopartikeln dieser Materialien ist.

2. Das Verfahren zur Herstellung einer photovoltaischen Zelle, wobei eine Schicht beinhaltend ZnO und ZnMgO, bedeckt durch eine abgeschiedene transparente ZnO:Al-Schicht mit einem oberen elektrischen Kontakt, auf einem Substrat vom P-Typ mit einem unteren elektrischen Kontakt abgeschieden wird, wobei eine Schicht von ZnO-Nanostrukturen in Form von mit einer ZnMgO-Schicht (5) bedeckten Nanostäben auf dem Siliziumsubstrat (1) gebildet wird, wobei zum Bilden der Schicht von ZnO-Nanostrukturen das Substrat (1) als erstes mit einer Nukleationsschicht (3) bedeckt wird und dann das Substrat (1) mit der Nukleationsschicht (3) in einer Reaktionsmixtur platziert wird mit pH von 6,5-12, beinhaltend ein Lösungsmittel, mindestens einen Sauerstoff-Ausgangsstoff und mindestens einen Zink-Ausgangsstoff, mit einer Zink-Konzentration von 0,001 M/dm3 bis 1 M/dm3, aufgeheizt auf eine Temperatur von 30-95°C und gehalten auf dieser Temperatur für mindestens eine Sekunde, und bei Abschluss des Verfahrens Unreinheiten von den kristallisierten Nanostrukturen (4) entfernt werden, vorzugsweise durch Tempern für mindestens eine Sekunde in der Temperatur von ≥ 100°C, wonach die ZnO-Nanostrukturen mit einer mindestens 1 nm dicken ZnMgO-Schicht (5) in einem ALD-Verfahren bedeckt werden und die auf diese Weise erzeugte aktive Schicht mit einer transparenten ZnO:Al-Elektrode (6) bedeckt wird, auf welcher der obere elektrische Kontakt (7) gemacht wird.

3. Das Verfahren nach Anspruch 2, **dadurch gekennzeichnet, dass** die Nukleationsschicht (3) auf dem Substrat (1) mittels Kathodenzerstäubung von Gold, Silber oder Nanopartikeln dieser Materialien aufgebracht ist.

4. Das Verfahren nach Anspruch 2, **dadurch gekennzeichnet, dass** die Nukleationsschicht (3) eine ZnO-Schicht ist oder auf das Substrat (1) aufgebrachte ZnO-Nanopartikel sind, welche aus einer Lösung oder durch Tempern von aus einer Lösung abgeschiedenen Zinksalzen gewonnen sind, oder die in mindestens 1 ALD-Zyklus abgeschieden sind, wobei der Ausgangsstoff von Zink Diethylzink, Dimethylzink oder Zinkchlorid ist, und wobei der Ausgangsstoff von Sauerstoff Wasser, Ozon oder Sauerstoffplasma ist.

5. Das Verfahren nach Anspruch 2, **dadurch gekennzeichnet, dass** der Sauerstoff-Ausgangsstoff in der Reaktionsmixtur Wasser ist und der Zink-Ausgangsstoff Zinkazetat ist.

6. Das Verfahren nach Anspruch 2, **dadurch gekennzeichnet, dass** die ZnMgO-Schicht (5), mit der die Nanostäbe (4) der aktiven Schicht bedeckt sind, in mindestens 10 ALD-Zyklen abgeschieden wird, nutzend Diethylzink, Dimethylzink oder Zinkchlorid als Zink-Ausgangsstoff, Di(cyclopentadienyl)magnesium oder Bis(Methylcyclopentadienyl)magnesium als Mg-Ausgangsstoff, und Ozon oder Sauerstoffplasma als Sauerstoff-Ausgangsstoff.

7. Das Verfahren nach Anspruch 2, **dadurch gekennzeichnet, dass** die transparente ZnO:AI-Schicht (6) in mindestens 100 ALD-Zyklen abgeschieden wird, nutzend Diethylzink, Dimethylzink oder Zinkchlorid als Zink-Ausgangsstoff, Ozon oder Sauerstoffplasma als Sauerstoff-Ausgangsstoff, und Trimethylaluminium als Aluminium-Ausgangsstoff.

## Revendications

1. Structure de cellule photovoltaïque, contenant un substrat (1) de silicium à semiconducteur de type p avec un contact électrique inférieur (2), avec une couche comprenant ZnO et ZnMgO recouverte d'une couche conductrice transparente (6), de préférence une couche ZnO:Al, avec un contact électrique supérieur (7), dans laquelle la couche active est une jonction Si/ZnO/ZnMgO, dans laquelle une couche de nanostructures (4) de ZnO de la hauteur de 100 nm jusqu'à 2000 nm est recouverte d'une couche de ZnMgO (5) de 1 nm à 2000 nm d'épaisseur, la couche de ZnMgO (5) ayant un mode de croissance en colonne sur les nanostructures (4) de ZnO, dans laquelle une couche de nucléation (3) sur le substrat (1) de silicium pour la croissance des nanostructures (4) de ZnO est une couche d'or, d'argent ou de ZnO, ou de nanoparticules de ces matériaux.

2. Procédé de production d'une cellule photovoltaïque, dans laquelle une couche contenant ZnO et ZnMgO recouverte d'une couche ZnO:Al transparente déposée avec un contact électrique supérieur, est déposée sur un substrat de type p avec un contact électrique inférieur, dans laquelle une couche de nanostructures de ZnO sous forme de bâtonnets nanométriques recouverts d'une couche de ZnMgO (5) est créée sur un substrat (1) de silicium, dans laquelle, afin de créer la couche de nanostructures de ZnO, le substrat (1) est d'abord recouvert d'une couche de nucléation (3) et ensuite, le substrat (1) avec la couche de nucléation (3) est placé dans un mélange réactionnel avec un pH de 6,5 à 12, contenant un solvant, au moins un précurseur d'oxygène et au moins un précurseur de zinc, la concentration en zinc étant de 0,001 M/dm3 à 1 M/dm3, chauffé jusqu'à la température de 30 à 95 °C et maintenu à cette température pendant au moins 1 seconde, et à la fin du processus, des impuretés sont éliminées des nanostructures (4) cristallisées, de préférence par recuit pendant au moins 1 seconde à la température de ≥ 100 °C, après quoi les nanostructures de ZnO sont recouvertes d'une couche de ZnMgO (5) d'au moins 1 nm d'épaisseur dans un processus de dépôt de couche atomique, ALD, et la couche active ainsi créée est recouverte d'une électrode de ZnO:Al transparente (6) sur laquelle le contact électrique supérieur (7) est réalisé.

3. Procédé selon la revendication 2, **caractérisé en ce que** la couche de nucléation (3) est déposée sur le substrat (1) au moyen d'une pulvérisation cathodique d'or, d'argent ou de nanoparticules de ces métaux.

4. Procédé selon la revendication 2, **caractérisé en ce que** la couche de nucléation (3) est une couche de ZnO ou des nanoparticules de ZnO déposées sur le substrat (1) à partir d'une solution ou obtenues par recuit de sels de zinc déposés à partir d'une solution, ou déposées dans au moins 1 cycle ALD, le précurseur du zinc étant le diéthylzinc, le diméthylzinc ou le chlorure de zinc, et le précurseur de l'oxygène étant l'eau, l'ozone ou le plasma d'oxygène.

5. Procédé selon la revendication 2, **caractérisé en ce que** le précurseur d'oxygène dans le mélange de réaction est l'eau, et le précurseur de zinc est l'acétate de zinc.

6. Procédé selon la revendication 2, **caractérisé en ce que** la couche de ZnMgO (5), dont les bâtonnets nanométriques de couche active (4) sont recouverts, est déposée en au moins 10 cycles ALD, en utilisant le diéthylzinc, le diméthylzinc ou le chlorure de zinc comme précurseur de zinc, le bis (cyclopentadiényl) magnésium ou le bis (méthylcyclopentadiényl) magnésium comme précurseur de Mg, et l'eau, l'ozone ou le plasma d'oxygène comme précurseur d'oxygène.

7. Procédé selon la revendication 2, **caractérisé en ce que** la couche de ZnO:Al transparente (6) est déposée en au moins 100 cycles ALD, en utilisant le diéthylzinc, le diméthylzinc ou le chlorure de zinc comme précurseur de zinc, l'eau, l'ozone ou le plasma d'oxygène comme précurseur d'oxygène, et le triméthylaluminium comme précurseur d'aluminium.
